(19)

Europäisches
Patentamt
European
Patent Office
Office européen
des brevets

(11)     **EP 4 495 667 A1**

(12)     **EUROPEAN PATENT APPLICATION**
published in accordance with Art. 153(4) EPC

(43) Date of publication:
**22.01.2025 Bulletin 2025/04**

(21) Application number: **23770582.7**

(22) Date of filing: **08.03.2023**

(51) International Patent Classification (IPC):
*G02B 27/02* (2006.01)      *G02B 3/00* (2006.01)
*G02B 5/00* (2006.01)       *G02B 5/08* (2006.01)
*G02B 5/30* (2006.01)       *G02B 13/00* (2006.01)
*G02B 17/08* (2006.01)      *G02C 7/00* (2006.01)
*G02F 1/13* (2006.01)       *G02F 1/13363* (2006.01)
*G02F 1/1337* (2006.01)     *G09F 9/00* (2006.01)
*H04N 5/64* (2006.01)       *H04N 5/66* (2006.01)
*H04N 13/344* (2018.01)     *H04N 13/346* (2018.01)
*H05B 33/02* (2006.01)      *H05B 33/10* (2006.01)
*H05B 33/24* (2006.01)      *H10K 50/00* (2023.01)
*H10K 59/00* (2023.01)

(52) Cooperative Patent Classification (CPC):
**G02B 3/00; G02B 5/00; G02B 5/08; G02B 5/30;**
**G02B 13/00; G02B 17/08; G02B 27/02; G02C 7/00;**
**G02F 1/13; G02F 1/13363; G02F 1/1337;**
**G09F 9/00; H04N 5/64; H04N 5/66; H04N 13/344;**
(Cont.)

(86) International application number:
**PCT/JP2023/008811**

(87) International publication number:
**WO 2023/176626 (21.09.2023 Gazette 2023/38)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **14.03.2022   JP 2022039285**
**14.03.2022   JP 2022039286**
**10.05.2022   JP 2022077631**
**10.05.2022   JP 2022077632**
**10.05.2022   JP 2022077633**
**10.05.2022   JP 2022077634**
**10.05.2022   JP 2022077657**
**10.05.2022   JP 2022077658**
**10.05.2022   JP 2022077659**
**10.05.2022   JP 2022077676**

**10.05.2022   JP 2022077677**
**10.05.2022   JP 2022077678**
**10.05.2022   JP 2022077679**
**28.12.2022   JP 2022212219**

(71) Applicant: **Nitto Denko Corporation**
**Ibaraki-shi, Osaka 567-8680 (JP)**

(72) Inventors:
• **NAMBARA Takuya**
**Ibaraki-shi, Osaka 567-8680 (JP)**
• **GOTO Shusaku**
**Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

(54)     **DISPLAY SYSTEM, DISPLAY METHOD, DISPLAY BODY, AND METHOD FOR**
**MANUFACTURING DISPLAY BODY**

(57)     Provided is a display system that can achieve a reduction in weight of a pair of VR goggles and an improvement in definition thereof. The display system according to an embodiment of the present invention is a display system configured to display an image to a user, including: a display element having a display surface configured to emit light representing an image to a front side through a polarizing member; a reflecting portion arranged on the front side of the display element, the reflecting portion including a reflection-type polarizing

**(Cont. next page)**

EP 4 495 667 A1

member and being configured to reflect the light emitted from the display element; a first lens portion arranged on an optical path between the display element and the reflecting portion; a half mirror arranged between the display element and the first lens portion, the half mirror being configured to transmit the light emitted from the display element and to reflect the light reflected by the reflecting portion toward the reflecting portion; a first $\lambda/4$ member arranged on an optical path between the display element and the half mirror; and a second $\lambda/4$ member arranged on an optical path between the half mirror and the reflecting portion, wherein an absolute value of a difference between an in-plane retardation (a) of the first $\lambda/4$ member and an in-plane retardation (b) of the second $\lambda/4$ member is 3.5 nm or less.

Fig.2(a)

Fig.2(b)

(52) Cooperative Patent Classification (CPC): (Cont.)
H04N 13/346; H05B 33/02; H05B 33/10;
H05B 33/24; H10K 50/00; H10K 59/00

## Description

Technical Field

The present invention relates to a display system, a display method, a display body, and a method of producing a display body.

Background Art

Image display apparatus typified by a liquid crystal display apparatus and an electroluminescence (EL) display apparatus (e.g., an organic EL display apparatus) have been rapidly gaining more widespread use. In the image display apparatus, an optical member, such as a polarizing member or a retardation member, has been generally used for achieving image display and improving the performance of the image display (see, for example, Patent Literature 1).
In recent years, new applications of the image display apparatus have been developed. For example, a pair of goggles (VR goggles) with a display for achieving virtual reality (VR) has started to be commercialized. A reduction in weight of the pair of VR goggles, an improvement in definition thereof, and the like have been desired because an investigation has been made on the utilization of the pair of goggles in various fields. The weight reduction may be achieved by, for example, thinning a lens to be used in the pair of VR goggles. Meanwhile, the development of an optical member suitable for a display system using a thin lens has also been desired.

Citation List

Patent Literature

[PTL 1] JP 2021-103286 A

Summary of Invention

Technical Problem

In view of the foregoing, a primary object of the present invention is to provide a display system that can achieve a reduction in weight of a pair of VR goggles and an improvement in definition thereof.

Solution to Problem

1. According to an embodiment of the present invention, there is provided a display system configured to display an image to a user, including: a display element having a display surface configured to emit light representing an image to a front side through a polarizing member; a reflecting portion arranged on the front side of the display element, the reflecting portion including a reflection-type polarizing member and being configured to reflect the light emitted from the display element; a first lens portion arranged on an optical path between the display element and the reflecting portion; a half mirror arranged between the display element and the first lens portion, the half mirror being configured to transmit the light emitted from the display element and to reflect the light reflected by the reflecting portion toward the reflecting portion; a first $\lambda/4$ member arranged on an optical path between the display element and the half mirror; and a second $\lambda/4$ member arranged on an optical path between the half mirror and the reflecting portion, wherein an absolute value of a difference between an in-plane retardation (a) of the first $\lambda/4$ member and an in-plane retardation (b) of the second $\lambda/4$ member is 3.5 nm or less.

2. In the display system according to Item 1, the in-plane retardation (a) of the first $\lambda/4$ member and the in-plane retardation (b) of the second $\lambda/4$ member may satisfy the following formula (I):

$$((a)-(b))/((a)+(b)/2) \leq 0.02 \cdots (I).$$

3. In the display system according to Item 1 or 2, the first $\lambda/4$ member and the second $\lambda/4$ member may each have an ISC value of 50 or less.

4. In the display system according to any one of Items 1 to 3, the first λ/4 member and the second λ/4 member may each have a thickness of 100 um or less.

5. In the display system according to any one of Items 1 to 4, the first λ/4 member and the second λ/4 member may each have a thickness variation of 1 um or less.

6. In the display system according to any one of Items 1 to 5, the first λ/4 member and the second λ/4 member may each have an ISC value of 1 or less per unit thickness.

7. In the display system according to any one of Items 1 to 6, a polarization direction of light, which has been emitted through the polarizing member, and a reflection axis of the reflection-type polarizing member may be substantially perpendicular to each other.

8. In the display system according to any one of Items 1 to 7, an angle formed by an absorption axis of the polarizing member in the display element and a slow axis of the first λ/4 member may be from 40° to 50°, and an angle formed by the absorption axis of the polarizing member in the display element and a slow axis of the second λ/4 member may be from 40° to 50°.

9. According to an embodiment of the present invention, there is provided a display body, including the display system of any one of Items 1 to 8.

10. According to an embodiment of the present invention, there is provided a method of producing a display body including the display system of any one of Items 1 to 8.

11. According to an embodiment of the present invention, there is provided a display method, including the steps of: passing light representing an image, which has been emitted through a polarizing member, through a first λ/4 member; passing the light, which has passed through the first λ/4 member, through a half mirror and a first lens portion; passing the light, which has passed through the half mirror and the first lens portion, through a second λ/4 member; reflecting the light, which has passed through the second λ/4 member, toward the half mirror with a reflecting portion including a reflection-type polarizing member; and enabling the light, which has been reflected by the reflecting portion and the half mirror, to penetrate through the reflecting portion with the second λ/4 member, wherein an absolute value of a difference between an in-plane retardation (a) of the first λ/4 member and an in-plane retardation (b) of the second λ/4 member is 3.5 nm or less.

Advantageous Effects of Invention

According to the display system of the embodiment of the present invention, the reduction in weight of the pair of VR goggles and the improvement in definition thereof can be achieved.

Brief Description of Drawings

FIG. **1** is a schematic view for illustrating the schematic configuration of a display system according to one embodiment of the present invention.

FIG. **2(a)** is a schematic view for illustrating an example of traveling of light in the display system illustrated in FIG. **1,** and FIG. **2(b)** is a schematic view for illustrating an example of a change in polarization state of light in the display system illustrated in FIG. **1.**

FIG. **3** is a view for describing a method of measuring a thickness variation.

FIG. **4** is a view for describing a method of measuring an ISC value.

Description of Embodiments

Embodiments of the present invention are described below with reference to the drawings. However, the present invention is not limited to these embodiments. For clearer illustration, some widths, thicknesses, shapes, and the like of respective portions may be schematically illustrated in the drawings in comparison to the embodiments. However, the widths, the thicknesses, the shapes, and the like are each merely an example, and do not limit the understanding of the present invention. In addition, in the drawings, the same or similar components are denoted by the same reference symbols, and repetitive description thereof is omitted in some cases.

(Definitions of Terms and Symbols)

The definitions of terms and symbols used herein are as described below.

(1) Refractive Indices (nx, ny, and nz)

"nx" represents a refractive index in a direction in which an in-plane refractive index is maximum (that is, slow axis direction), "ny" represents a refractive index in a direction perpendicular to a slow axis in a plane (that is, fast axis direction), and "nz" represents a refractive index in a thickness direction.

(2) In-plane Retardation (Re)

"Re($\lambda$)" refers to an in-plane retardation measured at 23°C with light having a wavelength of $\lambda$ nm. For example, "Re(550)" refers to an in-plane retardation measured at 23°C with light having a wavelength of 550 nm. The Re($\lambda$) is determined from the equation "Re($\lambda$)=(nx-ny)$\times$d" when the thickness of a layer (film) is represented by "d" (nm).

(3) Thickness Direction Retardation (Rth)

"Rth($\lambda$)" refers to a thickness direction retardation measured at 23°C with light having a wavelength of $\lambda$ nm. For example, "Rth(550)" refers to a thickness direction retardation measured at 23°C with light having a wavelength of 550 nm. The Rth($\lambda$) is determined from the equation "Rth($\lambda$)=(nx-nz)$\times$d" when the thickness of a layer (film) is represented by "d" (nm).

(4) Nz Coefficient

An Nz coefficient is determined from the equation "Nz=Rth/Re" .

(5) Angle

When reference is made to an angle herein, the angle encompasses both angles in a clockwise direction and a counterclockwise direction with respect to a reference direction unless otherwise stated. Accordingly, for example, the term "45°" means $\pm$45°. In addition, the phrase "substantially parallel" as used herein encompasses a case in which the angle falls within the range of 0°$\pm$10°, and the angle falls within the range of preferably 0°$\pm$5°, more preferably 0°$\pm$3°, still more preferably 0°$\pm$1°. The phrase "substantially perpendicular" as used herein encompasses a case in which the angle falls within the range of 90°$\pm$10°, and the angle falls within the range of preferably 90°$\pm$5°, more preferably 90°$\pm$3°, still more preferably 90°$\pm$1°.

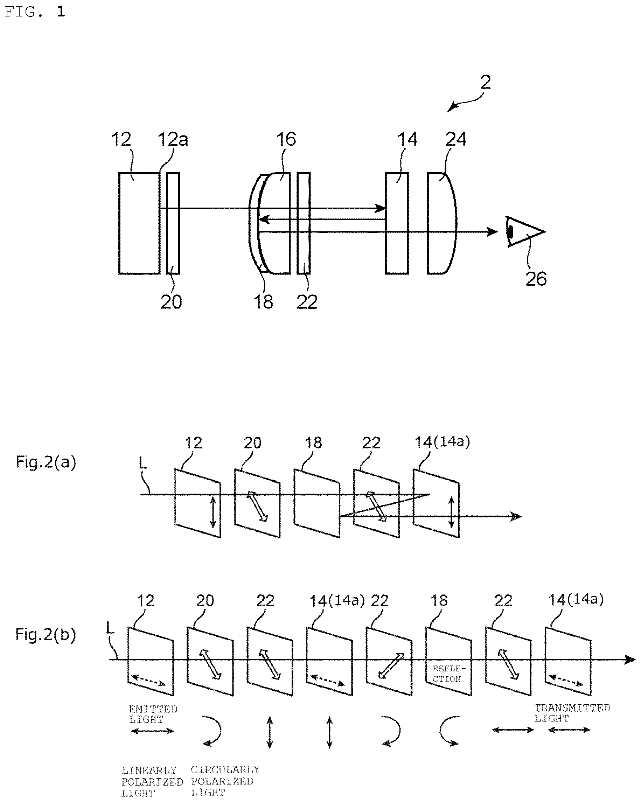

FIG. **1** is a schematic view for illustrating the schematic configuration of a display system according to one embodiment of the present invention. The arrangement, shapes, and the like of the respective constituents of a display system **2** are schematically illustrated in FIG. **1**. The display system **2** includes: a display element **12;** a reflecting portion **14** including a reflection-type polarizing member; a first lens portion **16;** a half mirror **18;** a first retardation member **20;** a second retardation member **22;** and a second lens portion **24.** The reflecting portion **14** is arranged on the front side of the display element **12,** that is, the display surface **12a** side thereof, and can reflect light emitted from the display element **12.** The first lens portion **16** is arranged on an optical path between the display element **12** and the reflecting portion **14,** and the half mirror **18** is arranged between the display element **12** and the first lens portion **16.** The first retardation member **20** is arranged on an optical path between the display element **12** and the half mirror **18,** and the second retardation member **22** is arranged on an optical path between the half mirror **18** and the reflecting portion **14.**

The display element **12** is, for example, a liquid crystal display or an organic EL display, and has a display surface **12a** for displaying an image. The light to be emitted from the display surface **12a** passes through, for example, a polarizing member (typically, a polarizing film) that may be incorporated into the display element **12** to be emitted as first linearly polarized light.

The first retardation member **20** is a $\lambda$/4 member that can convert the first linearly polarized light, which has entered the first retardation member **20,** into first circularly polarized light (the first retardation member is hereinafter sometimes referred to as "first $\lambda$/4 member"). The first retardation member **20** may be arranged integrally with the display element **12.**

The half mirror **18** transmits the light emitted from the display element **12,** and reflects the light reflected by the reflecting portion **14** toward the reflecting portion **14.** The half mirror **18** is arranged integrally with the first lens portion **16.**

The second retardation member **22** is a λ/4 member that enables the light, which has been reflected by the reflecting portion **14** and the half mirror **18,** to penetrate through the reflecting portion **14** including a reflection-type polarizing member (the second retardation member is hereinafter sometimes referred to as "second λ/4 member"). The second retardation member **22** may be arranged integrally with the first lens portion **16.**

The first circularly polarized light emitted from the first λ/4 member **20** passes through the half mirror **18** and the first lens portion **16,** and is converted into second linearly polarized light by the second λ/4 member **22.** The second linearly polarized light emitted from the second λ/4 member **22** is reflected toward the half mirror **18** without penetrating through the reflection-type polarizing member in the reflecting portion **14.** At this time, the polarization direction of the second linearly polarized light that has entered the reflection-type polarizing member in the reflecting portion **14** is the same direction as that of the reflection axis of the reflection-type polarizing member. Accordingly, the second linearly polarized light that has entered the reflecting portion **14** is reflected by the reflection-type polarizing member.

The second linearly polarized light reflected by the reflecting portion **14** is converted into second circularly polarized light by the second λ/4 member **22,** and the second circularly polarized light emitted from the second λ/4 member **22** passes through the first lens portion **16,** and is reflected by the half mirror **18.** The circularly polarized light reflected by the half mirror **18** passes through the first lens portion **16,** and is converted into third linearly polarized light by the second λ/4 member **22.** The third linearly polarized light penetrates through the reflection-type polarizing member in the reflecting portion **14.** At this time, the polarization direction of the third linearly polarized light that has entered the reflection-type polarizing member in the reflecting portion **14** is the same direction as that of the transmission axis of the reflection-type polarizing member. Accordingly, the third linearly polarized light that has entered the reflecting portion **14** penetrates through the reflection-type polarizing member.

The light that has penetrated through the reflecting portion **14** passes through the second lens portion **24** to enter an eye **26** of a user.

For example, the absorption axis of the polarizing member in the display element **12** and the reflection axis of the reflection-type polarizing member in the reflecting portion **14** may be arranged substantially parallel to each other, or may be arranged substantially perpendicular to each other. An angle formed by the absorption axis of the polarizing member in the display element **12** and the slow axis of the first retardation member **20** is, for example, from 40° to 50°, and may be from 42° to 48°, or may be about 45°. An angle formed by the absorption axis of the polarizing member in the display element **12** and the slow axis of the second retardation member **22** is, for example, from 40° to 50°, and may be from 42° to 48°, or may be about 45°.

The in-plane retardation Re(550) of the first retardation member **20** is, for example, from 100 nm to 190 nm, and may be from 110 nm to 180 nm, may be from 130 nm to 160 nm, or may be from 135 nm to 155 nm.

The first retardation member **20** preferably shows such a reverse wavelength dispersion characteristic that its retardation value increases with an increase in wavelength of measurement light. The ratio "Re(450)/Re(550)" of the first retardation member **20** is, for example, less than 1, and may be 0.95 or less. Further, the ratio may be less than 0.90, or may be 0.85 or less. The ratio "Re(450)/Re(550)" of the first retardation member **20** is, for example, 0.75 or more.

In one embodiment, the first retardation member **20** satisfies all of Re(400)/Re(550)<0.85, Re(650)/Re(550)>1.03, and Re(750)/Re(550)>1.05. The first retardation member **20** preferably satisfies at least one selected from 0.65<Re(400)/Re(550)<0.80 (preferably 0.7<Re(400)/Re(550)<0.75), 1.0<Re(650)/Re(550)<1.25 (preferably 1.05<Re(650)/Re(550)<1.20), and 1.05<Re(750)/Re(550)<1.40 (preferably 1.08<Re(750)/Re(550)<1.36). The member more preferably satisfies at least two of the relationships, and still more preferably satisfies all of the relationships.

The refractive index characteristic of the first retardation member **20** preferably shows the relationship of $n_x > n_y \geq n_z$. The equation "$n_y = n_z$" as used herein encompasses not only a case in which the $n_y$ and the $n_z$ are completely equal to each other but also a case in which the $n_y$ and the $n_z$ are substantially equal to each other. Accordingly, the $n_y$ may be less than the $n_z$ to the extent that the effects of the present invention are not impaired. The Nz coefficient of the first retardation member **20** is preferably from 0.9 to 3, more preferably from 0.9 to 2.5, still more preferably from 0.9 to 1.5, particularly preferably from 0.9 to 1.3.

The ISC value of the first retardation member **20** is, for example, 50 or less, preferably 40 or less, more preferably 30 or less, still more preferably 20 or less. When the first retardation member **20** satisfies such ISC value, a display system excellent in viewability can be achieved. For example, when such ISC value is satisfied, the uniformity of the in-plane retardation can be improved, and as a result, light leakage or the like in a reflecting portion to be described later can be suppressed. The ISC value may serve as an indicator of smoothness or unevenness.

The thickness variation of the first retardation member **20** is preferably 1 um or less, more preferably 0.8 um or less, still more preferably 0.6 um or less, even still more preferably 0.4 um or less. With such thickness variation, for example, the ISC value can be satisfactorily achieved. Herein, the thickness variation may be determined by measuring the thickness of a first portion positioned in the plane of a retardation member, and a thickness at a position distant from the first portion by a predetermined distance (e.g., from 5 mm to 15 mm) in any appropriate direction (e.g., an upward direction, a downward direction, a leftward direction, and a rightward direction).

The ISC value per unit thickness of the first retardation member **20** is preferably 1 or less, more preferably 0.7 or less, still more preferably 0.5 or less. The ISC value per unit thickness may be determined by, for example, dividing the ISC value by a thickness (unit: um).

The first retardation member **20** is formed from any appropriate material that may satisfy the above-mentioned characteristics. The first retardation member **20** may be, for example, a stretched film of a resin film or an alignment fixed layer of a liquid crystal compound. The stretched film of the resin film is sometimes referred to as "retardation film."

A resin to be incorporated into the resin film is, for example, a polycarbonate-based resin, a polyester carbonate-based resin, a polyester-based resin, a polyvinyl acetal-based resin, a polyarylate-based resin, a cyclic olefin-based resin, a cellulose-based resin, a polyvinyl alcohol-based resin, a polyamide-based resin, a polyimide-based resin, a polyether-based resin, a polystyrene-based resin, or an acrylic resin. Those resins may be used alone or in combination thereof (e.g., as a blend or copolymer thereof). When the first retardation member **20** shows a reverse wavelength dispersion characteristic, a resin film containing a polycarbonate-based resin or a polyester carbonate-based resin (hereinafter sometimes simply referred to as "polycarbonate-based resin") may be suitably used.

Any appropriate polycarbonate-based resin may be used as the polycarbonate-based resin as long as the effects of the present invention are obtained. For example, the polycarbonate-based resin includes a structural unit derived from a fluorene-based dihydroxy compound, a structural unit derived from an isosorbide-based dihydroxy compound, and a structural unit derived from at least one dihydroxy compound selected from the group consisting of: an alicyclic diol; an alicyclic dimethanol; di-, tri-, or polyethylene glycol; and an alkylene glycol or a spiroglycol. The polycarbonate-based resin preferably includes a structural unit derived from a fluorene-based dihydroxy compound, a structural unit derived from an isosorbide-based dihydroxy compound, and a structural unit derived from an alicyclic dimethanol and/or a structural unit derived from di-, tri-, or polyethylene glycol, and more preferably includes a structural unit derived from a fluorene-based dihydroxy compound, a structural unit derived from an isosorbide-based dihydroxy compound, and a structural unit derived from di-, tri-, or polyethylene glycol. The polycarbonate-based resin may include a structural unit derived from any other dihydroxy compound as required. Details about the polycarbonate-based resin that may be suitably used in the first retardation member and a method of forming the first retardation member are described in, for example, JP 2014-10291 A, JP 2014-26266 A, JP 2015-212816 A, JP 2015-212817 A, and JP 2015-212818 A, the descriptions of which are incorporated herein by reference.

The alignment fixed layer of the liquid crystal compound is such a layer that the liquid crystal compound is aligned in a predetermined direction in the layer, and its alignment state is fixed. The term "alignment fixed layer" is a concept encompassing an alignment cured layer obtained by curing a liquid crystal monomer as described later. In the first retardation member, the molecules of a rod-shaped liquid crystal compound are typically aligned under the state of being lined up in the slow axis direction of the first retardation member (homogeneous alignment). Examples of the rod-shaped liquid crystal compound include a liquid crystal polymer and a liquid crystal monomer. The liquid crystal compound is preferably polymerizable. When the liquid crystal compound is polymerizable, the alignment state of the liquid crystal compound can be fixed by aligning the liquid crystal compound and then polymerizing the compound.

The alignment fixed layer of the liquid crystal compound (liquid crystal alignment fixed layer) may be formed by: subjecting the surface of a predetermined substrate to alignment treatment; applying an application liquid containing a liquid crystal compound to the surface; aligning the liquid crystal compound in a direction corresponding to the alignment treatment; and fixing the alignment state. Any appropriate alignment treatment may be adopted as the alignment treatment. Specific examples thereof include mechanical alignment treatment, physical alignment treatment, and chemical alignment treatment. Specific examples of the mechanical alignment treatment include rubbing treatment and stretching treatment. Specific examples of the physical alignment treatment include magnetic field alignment treatment and electric field alignment treatment. Specific examples of the chemical alignment treatment include an oblique deposition method and photoalignment treatment. Any appropriate conditions may be adopted as treatment conditions for the various alignment treatments in accordance with purposes.

The alignment of the liquid crystal compound is performed through treatment at a temperature at which the liquid crystal compound shows a liquid crystal phase depending on the kind of the liquid crystal compound. When the treatment at such temperature is performed, the liquid crystal compound adopts a liquid crystal state, and the liquid crystal compound is aligned in accordance with the alignment treatment direction of the surface of the substrate.

In one embodiment, the fixation of the alignment state is performed by cooling the liquid crystal compound aligned as described above. When the liquid crystal compound is polymerizable or cross-linkable, the fixation of the alignment state is performed by subjecting the liquid crystal compound aligned as described above to polymerization treatment or cross-linking treatment.

Any appropriate liquid crystal polymer and/or liquid crystal monomer is used as the liquid crystal compound. The liquid crystal polymers and the liquid crystal monomers may each be used alone or in combination thereof. Specific examples of the liquid crystal compound and a method of producing the liquid crystal alignment fixed layer are described in, for example, JP 2006-163343 A, JP 2006-178389 A, and WO 2018/123551 A1, the descriptions of which are incorporated herein by reference.

The thickness of the first retardation member 20 is preferably 100 um or less. Specifically, the thickness of the first retardation member **20** including the stretched film of the resin film is, for example, from 10 um to 100 $\mu$m, preferably from 10 um to 70 $\mu$m, more preferably from 10 um to 60 $\mu$m, still more preferably from 20 um to 50 um. In addition, the thickness of the first retardation member **20** including the liquid crystal alignment fixed layer is, for example, from 1 um to 10 $\mu$m, preferably from 1 um to 8 $\mu$m, more preferably from 1 um to 6 $\mu$m, still more preferably from 1 um to 4 $\mu$m.

The in-plane retardation Re(550) of the second retardation member **22** is, for example, from 100 nm to 190 nm, and may be from 110 nm to 180 nm, from 130 nm to 160 nm, or from 135 nm to 155 nm.

The second retardation member **22** preferably shows such a reverse wavelength dispersion characteristic that its retardation value increases with an increase in wavelength of measurement light. The ratio "Re(450)/Re(550)" of the second retardation member **22** is, for example, less than 1, and may be 0.95 or less, may be less than 0.90, or may be 0.85 or less. The ratio "Re(450)/Re(550)" of the second retardation member **22** is, for example, 0.75 or more.

In one embodiment, the second retardation member **22** satisfies all of Re(400)/Re(550)<0.85, Re(650)/Re(550) >1.03, and Re(750)/Re(550)>1.05. The second retardation member **22** preferably satisfies at least one selected from 0.65<Re(400)/Re(550)<0.80 (preferably 0.7<Re(400)/Re(550)<0.75), 1.0<Re(650)/Re(550)<1.25 (preferably 1.05<Re(650)/Re(550)<1.20), and 1.05<Re(750)/Re(550)<1.40 (preferably 1.08<Re(750)/Re(550)<1.36), more preferably satisfies at least two of the relationships, and still more preferably satisfies all of the relationships.

The refractive index characteristic of the second retardation member **22** preferably shows the relationship of nx>ny $\geq$nz. The equation "ny=nz" as used herein encompasses not only a case in which the ny and the nz are completely equal to each other but also a case in which the ny and the nz are substantially equal to each other. Accordingly, the ny may be less than the nz to the extent that the effects of the present invention are not impaired. The Nz coefficient of the second retardation member **22** is preferably from 0.9 to 3, more preferably from 0.9 to 2.5, still more preferably from 0.9 to 1.5, particularly preferably from 0.9 to 1.3.

The ISC value of the second retardation member **22** is, for example, 50 or less, preferably 40 or less, more preferably 30 or less, still more preferably 20 or less. When the second retardation member **22** satisfies such ISC value, a display system excellent in viewability can be achieved. For example, when such ISC value is satisfied, the uniformity of the in-plane retardation can be improved, and as a result, light leakage or the like in a reflecting portion to be described later can be suppressed. The ISC value may serve as an indicator of smoothness or unevenness.

The thickness variation of the second retardation member **22** is preferably 1 um or less, more preferably 0.8 um or less, still more preferably 0.6 um or less, even still more preferably 0.4 um or less. With such thickness variation, for example, the ISC value can be satisfactorily achieved.

The ISC value per unit thickness of the second retardation member **22** is preferably 1 or less, more preferably 0.7 or less, still more preferably 0.5 or less.

The second retardation member **22** is formed from any appropriate material that may satisfy the above-mentioned characteristics. The second retardation member **22** may be, for example, a stretched film of a resin film or an alignment fixed layer of a liquid crystal compound. The same description as that of the first retardation member **20** may be applied to the second retardation member **22** including the stretched film of the resin film or the alignment fixed layer of the liquid crystal compound. The first retardation member **20** and the second retardation member **22** may be members having the same configuration (e.g., a formation material, a thickness, or an optical characteristic), or may be members having different configurations.

The thickness of the second retardation member **22** is preferably 100 um or less. Specifically, the thickness of the second retardation member **22** including the stretched film of the resin film is, for example, from 10 um to 100 $\mu$m, preferably from 10 um to 70 $\mu$m, more preferably from 10 um to 60 $\mu$m, still more preferably from 20 um to 50 um. The thickness of the second retardation member **22** including the liquid crystal alignment fixed layer is, for example, from 1 um to 10 $\mu$m, preferably from 1 um to 8 $\mu$m, more preferably from 1 um to 6 $\mu$m, still more preferably from 1 um to 4 $\mu$m.

The absolute value of the difference between an in-plane retardation (a) of the first retardation member and an in-plane retardation (b) of the second retardation member is 3.5 nm or less, preferably 3.0 nm or less, more preferably 2.5 nm or less, still more preferably 2.0 nm or less, particularly preferably 1.5 nm or less, most preferably 1.0 nm or less. In one embodiment, the in-plane retardations (a) and (b) are each a value of Re(590).

The in-plane retardation (a) of the first retardation member and the in-plane retardation (b) of the second retardation member preferably satisfy the following formula (I) .

$$((a)-(b))/((a)+(b)/2) \leq 0.02 \cdots (I)$$

((a)-(b))/((a)+(b)/2)$\leq$0.015 is more preferred, and ((a)-(b))/((a)+(b)/2)$\leq$0.01 is still more preferred.

The reflecting portion **14** may include an absorption-type polarizing member in addition to the reflection-type polarizing member. The absorption-type polarizing member may be arranged on the front side of the reflection-type polarizing member. The reflection axis of the reflection-type polarizing member and the absorption axis of the absorption-type polarizing member may be arranged substantially parallel to each other, and the transmission axis of the reflection-type polarizing member and the transmission axis of the absorption-type polarizing member may be arranged substantially parallel to each other. When the reflecting portion **14** includes the absorption-type polarizing member, the reflecting portion **14** may include a laminate including the reflection-type polarizing member and the absorption-type polarizing member.

The reflection-type polarizing member can transmit polarized light (typically, linearly polarized light) parallel to its transmission axis while maintaining the polarization state of the light, and can reflect light in any other polarization state. The cross transmittance (Tc) of the reflection-type polarizing member may be, for example, from 0.01% to 3%. The single layer transmittance (Ts) of the reflection-type polarizing member may be, for example, from 43% to 49%, preferably from 45% to 47%. The polarization degree (P) of the reflection-type polarizing member may be, for example, from 92% to 99.99%. The reflection-type polarizing member typically includes a film having a multilayer structure (sometimes referred to as "reflection-type polarizing film"). A commercial product of the reflection-type polarizing film is, for example, a product available under the product name "DBEF" or "APF" from 3M Company, or a product available under the product name "APCF" from Nitto Denko Corporation.

The absorption-type polarizing member may typically include a resin film containing a dichroic substance (sometimes referred to as "absorption-type polarizer"). The thickness of the absorption-type polarizer is, for example, 1 um or more and 20 um or less, and may be 2 um or more and 15 um or less, may be 12 um or less, may be 10 um or less, may be 8 um or less, or may be 5 um or less.

The absorption-type polarizer may be produced from a single-layer resin film, or may be produced by using a laminate of two or more layers.

When the absorption-type polarizer is produced from the single-layer resin film, the absorption-type polarizer may be obtained by, for example, subjecting a hydrophilic polymer film, such as a polyvinyl alcohol (PVA)-based film, a partially formalized PVA-based film, or an ethylene-vinyl acetate copolymer-based partially saponified film, to dyeing treatment with a dichroic substance such as iodine or a dichroic dye, stretching treatment, and so on. Of such polarizers, an absorption-type polarizer obtained by dyeing a PVA-based film with iodine and uniaxially stretching the dyed film is preferred.

The dyeing with iodine is performed by, for example, immersing the PVA-based film in an aqueous solution of iodine. The stretching ratio of the uniaxial stretching is preferably from 3 times to 7 times. The stretching may be performed after the dyeing treatment, or may be performed while the dyeing is performed. Alternatively, the dyeing may be performed after the stretching. The PVA-based film is subjected to swelling treatment, cross-linking treatment, washing treatment, drying treatment, or the like as required.

When the absorption-type polarizer is produced by using the above-mentioned laminate of two or more layers, the laminate is, for example, a laminate of a resin substrate and a PVA-based resin layer (PVA-based resin film) laminated on the resin substrate or a laminate of a resin substrate and a PVA-based resin layer formed on the resin substrate through application. The absorption-type polarizer obtained by using the laminate of the resin substrate and the PVA-based resin layer formed on the resin substrate through application may be produced, for example, by: applying a PVA-based resin solution to the resin substrate; drying the solution to form the PVA-based resin layer on the resin substrate, to thereby provide the laminate of the resin substrate and the PVA-based resin layer; and stretching and dyeing the laminate to turn the PVA-based resin layer into the absorption-type polarizer. In this embodiment, a polyvinyl alcohol-based resin layer containing a halide and a polyvinyl alcohol-based resin is preferably formed on one side of the resin substrate. The stretching typically includes stretching the laminate under a state in which the laminate is immersed in an aqueous solution of boric acid. Further, the stretching may further include in-air stretching of the laminate at high temperature (e.g., 95°C or more) before the stretching in the aqueous solution of boric acid as required. In addition, in this embodiment, the laminate is preferably subjected to drying shrinkage treatment, which includes heating the laminate, while conveying the laminate in its lengthwise direction, to shrink the laminate by 2% or more in its widthwise direction. The production method of this embodiment typically includes subjecting the laminate to in-air auxiliary stretching treatment, dyeing treatment, underwater stretching treatment, and drying shrinkage treatment in the stated order. When the auxiliary stretching is introduced, even in the case where PVA is applied onto a thermoplastic resin, the crystallinity of PVA can be improved, and hence high optical characteristics can be achieved. In addition, when the alignment property of PVA is improved in advance simultaneously with the crystallinity improvement, problems, such as a reduction in alignment property of PVA and the dissolution thereof, can be prevented at the time of the immersion of the laminate in water in the subsequent dyeing step or stretching step, and hence high optical characteristics can be achieved. Further, in the case where the PVA-based resin layer is immersed in a liquid, the disturbance of the alignment of the molecules of polyvinyl alcohol and reductions in alignment properties thereof can be suppressed as compared to those in the case where the PVA-based resin layer is free of any halide. Thus, the optical characteristics of the absorption-type polarizer to be obtained through treatment steps performed by immersing the laminate in a liquid, such as the dyeing treatment and the underwater stretching treatment, can be improved. Further, the optical characteristics can be improved by shrinking the laminate in its widthwise direction through the drying shrinkage treatment. The resultant laminate of the resin substrate and the absorption-type polarizer may be used as it is (that is, the resin substrate may be used as a protective layer for the absorption-type polarizer), or may be used by laminating any appropriate protective layer in accordance with purposes on the peeled surface on which the resin substrate has been peeled from the laminate of the resin substrate and the absorption-type polarizer, or on a surface on an opposite side to the peeled surface. Details about such method of producing the absorption-type polarizer are described in, for example, JP 2012-73580 A or JP 6470455 B1, the description of which is incorporated herein by reference in its entirety.

The cross transmittance (Tc) of the absorption-type polarizing member (absorption-type polarizer) is preferably 0.5% or less, more preferably 0.1% or less, still more preferably 0.05% or less. The single layer transmittance (Ts) of the absorption-type polarizing member (absorption-type polarizer) is, for example, from 41.0% to 45.0%, preferably 42.0% or more. The polarization degree (P) of the absorption-type polarizing member (absorption-type polarizer) is, for example, from 99.0% to 99.997%, preferably 99.9% or more.

FIGS. 2 are each a schematic view for illustrating an example of traveling of light or a change in polarization state thereof in the display system illustrated in FIG. 1. Specifically, FIG. 2(a) is a schematic view for illustrating an example of traveling of light in the display system, and FIG. 2(b) is a schematic view for illustrating an example of a change in polarization state of the light resulting from its penetration through each member or its reflection by each member in the display system. In FIGS. 2, the solid arrow attached to the display element 12 indicates the absorption axis direction of the polarizing member in the display element 12, the arrow attached to each of the first retardation member 20 and the second retardation member 22 indicates a slow axis direction, the solid arrow attached to a reflection-type polarizing member 14a in the reflecting portion 14 indicates a reflection axis direction, and the dashed arrow indicates the transmission axis direction of each polarizing member. In the illustrated example, the slow axes of the first retardation member 20 and the second retardation member 22 are arranged substantially parallel to each other. The absorption axis of the polarizing member in the display element 12 and the reflection axis of the reflection-type polarizing member 14a in the reflecting portion 14 are arranged substantially parallel to each other. In other words, the polarization direction of light, which has been emitted through the polarizing member in the display element 12, and the reflection axis of the reflection-type polarizing member 14a in the reflecting portion 14 are substantially perpendicular to each other.

Light L emitted as the first linearly polarized light from the display element 12 through the polarizing member is converted into the first circularly polarized light by the first $\lambda/4$ member 20. The first circularly polarized light passes through the half mirror 18 and the first lens portion 16 (not shown in FIGS. 2), and is converted into second linearly polarized light whose polarization direction is perpendicular to that of the first linearly polarized light by the second $\lambda/4$ member 22. The polarization direction of the second linearly polarized light is the same direction as (substantially parallel to) that of the reflection axis of the reflection-type polarizing member 14a in the reflecting portion 14. Accordingly, the second linearly polarized light, which has entered the reflecting portion 14, is reflected toward the half mirror 18 by the reflection-type polarizing member 14a.

The second linearly polarized light reflected by the reflecting portion 14 is converted into second circularly polarized light by the second $\lambda/4$ member 22. The rotation direction of the second circularly polarized light is the same direction as the rotation direction of the first circularly polarized light. The second circularly polarized light emitted from the second $\lambda/4$ member 22 passes through the first lens portion 16, and is reflected by the half mirror 18 to be converted into third circularly polarized light that rotates in a direction opposite to that of the second circularly polarized light. The third circularly polarized light reflected by the half mirror 18 passes through the first lens portion 16, and is converted into the third linearly polarized light by the second $\lambda/4$ member 22. The polarization direction of the third linearly polarized light is perpendicular to the polarization direction of the second linearly polarized light, and is the same direction as (substantially parallel to) that of the transmission axis of the reflection-type polarizing member 14a. Accordingly, the third linearly polarized light can penetrate through the reflection-type polarizing member 14a. In addition, although not shown, when the reflecting portion includes the absorption-type polarizing member, the absorption-type polarizing member is arranged so that its absorption axis is substantially parallel to the reflection axis of the reflection-type polarizing member 14a, and hence the third linearly polarized light, which has penetrated through the reflection-type polarizing member 14a, can penetrate through the absorption-type polarizing member as it is.

The light that has penetrated through the reflecting portion 14 passes through the second lens portion 24 to enter the eye 26 of a user. As described above, in the display system according to the embodiment of the present invention, the first linearly polarized light, which has been emitted from the display element 12 through the polarizing member, penetrates through the $\lambda/4$ members four times in total, and then penetrates through the reflecting portion 14. Light leakage in the reflecting portion 14 can be suitably suppressed by setting the absolute value of the difference between the in-plane retardation (a) of the first retardation member 20 and the in-plane retardation (b) of the second retardation member 22 to 3.5 nm or less. As a result, the light that should be reflected or absorbed by the reflecting portion 14 can be suitably suppressed from being viewed as a residual image (ghost) by a user.

In FIG. 2(a), the slow axes of the first retardation member 20 and the second retardation member 22 are each arranged so as to form an angle of 45° counterclockwise with respect to the absorption axis of the polarizing member in the display element 12 when viewed from a display element 12 side. However, the slow axes may each be arranged so as to form an angle of 45° clockwise. Also in this case, the same description as that in the foregoing may be applied. In addition, in FIG. **2(a),** the slow axis of the first retardation member **20** and the slow axis of the second retardation member **22** are arranged substantially parallel to each other, but may be arranged substantially perpendicular to each other. For example, the slow axis of the first retardation member **20** and the slow axis of the second retardation member **22** may be arranged so that any one of the axes forms an angle of 45° counterclockwise with respect to the absorption axis of the polarizing member in the display element **12** and the other forms an angle of 45° clockwise with respect to the absorption axis of the polarizing member. In this case, unlike the example illustrated in FIG. **2(a),** the absorption axis of the polarizing member in the display element **12** and the reflection axis of the reflection-type polarizing member **14a** in the reflecting portion **14** may be arranged substantially perpendicular to each other.

Examples

The present invention is specifically described below by way of Examples. However, the present invention is by no means limited to these Examples. Test and evaluation methods in Examples and the like are as described below. The term "part(s)" means "part(s) by weight" unless otherwise stated, and the term "%" means "wt%" unless otherwise stated.

(1) Thickness

A thickness of 10 um or less was measured with a scanning electron microscope (manufactured by JEOL Ltd., product name: "JSM-7100F"). A thickness of more than 10 um was measured with a digital micrometer (manufactured by Anritsu Corporation, product name: "KC-351C").

(2) In-plane Retardation Re($\lambda$)

A central portion and both end portions in the widthwise direction of a retardation film were each cut into a square shape measuring 50 mm wide by 50 mm long so that one side thereof was parallel to the widthwise direction of the film. Thus, a sample was produced. The in-plane retardation of the sample at 23°C and each wavelength was measured with a Mueller matrix polarimeter (manufactured by Axometrics, Inc., product name: "AxoScan") .

(3) Single Layer Transmittance and Polarization Degree of Polarizing Film

The single layer transmittance Ts, parallel transmittance Tp, and cross transmittance Tc of a polarizing film were measured with a spectrophotometer (manufactured by Otsuka Electronics Co., Ltd., "LPF-200"). The Ts, the Tp, and the Tc are each a Y value measured with the two-degree field of view (C light source) of JIS Z 8701 and subjected to visibility correction. The polarization degree of the polarizing film was determined from the resultant Tp and Tc by using the following equation.

$$\texttt{Polarization degree (\%)=\{(Tp-Tc)/(Tp+Tc)\}}^{1/2}\texttt{×100}$$

(4) Thickness Variation

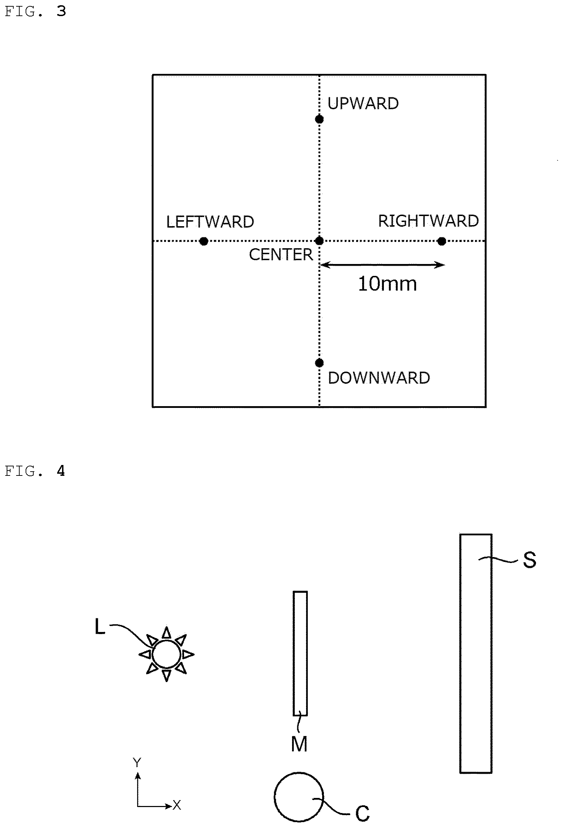

The retardation film was cut into a size measuring 100 mm by 100 mm to provide a measurement sample. As illustrated in FIG. **3,** thicknesses at five points in total, that is, the center of the measurement sample, and four points distant upward, downward, leftward, and rightward from the center by 10 mm were measured, and the difference between the maximum value and the minimum value was adopted as a thickness variation.

(5) ISC Value

An ISC value was measured for the retardation film with EyeScale-4W manufactured by I System Corporation. Specifically, in-plane unevenness was calculated as an ISC value in the ISC measurement mode of a 3CCD image sensor based on the specification of the measurement apparatus.

FIG. **4** is a view for describing a method of measuring an ISC value, and is a schematic view of the arrangement of a light source, a retardation film, a screen, and a CCD camera when seen from above. As illustrated in FIG. **4,** a light source **L,** a retardation film **M,** and a screen **S** were arranged in the stated order, and a transmission image projected on the screen **S** was measured with a CCD camera **C.** The retardation film **M** was bonded to an alkali-free glass plate (manufactured by Corning Incorporated, 1737), and was subjected to measurement under the state in which the glass plate was arranged on a light source **L** side.

The arrangement was performed so that the distance from the light source **L** to the retardation film **M** in an X-axis direction became from 10 cm to 60 cm. The arrangement was performed so that the distance from the light source **L** to the screen **S** in the X-axis direction became from 70 cm to 130 cm. The arrangement was performed so that the distance from the CCD camera **C** to the retardation film **M** in a Y-axis direction became from 3 cm to 30 cm. The arrangement was performed so that the distance from the CCD camera **C** to the screen **S** in the X-axis direction became from 70 cm to 130 cm.

[Production Example 1-1: Production of Retardation Film 1]

29.60 Parts by weight (0.046 mol) of bis[9-(2-phenoxycarbonylethyl)fluoren-9-yl]methane, 29.21 parts by weight (0.200 mol) of isosorbide (ISB), 42.28 parts by weight (0.139 mol) of spiroglycol (SPG), 63.77 parts by weight (0.298 mol) of diphenyl carbonate (DPC), and $1.19 \times 10^{-2}$ part by weight ($6.78 \times 10^{-5}$ mol) of calcium acetate monohydrate serving as a catalyst were loaded into a batch polymerization apparatus formed of two vertical reactors each including a stirring blade and a reflux condenser controlled to 100°C. After the inside of the reactor had been purged with nitrogen under reduced pressure, the inside was warmed with a heat medium, and stirring was started at the time point when the internal temperature became 100°C. 40 Minutes after the start of the temperature increase, the internal temperature was caused to reach 220°C, and such control that the temperature was held was performed. At the same time, a pressure reduction was started, and a pressure in the reactor was set to 13.3 kPa in 90 minutes after the temperature had reached 220°C. Phenol vapor produced as a byproduct along with a polymerization reaction was introduced into the reflux condenser at 100°C, a monomer component present in a trace amount in the phenol vapor was returned to the reactor, and the phenol vapor that did not condense was introduced into a condenser at 45°C and recovered. Nitrogen was introduced into the first reactor to return the pressure therein to the atmospheric pressure once, and then an oligomerized reaction liquid in the first reactor was transferred to the second reactor. Next, a temperature increase and a pressure reduction in the second reactor were started, and the internal temperature and the pressure were set to 240°C and 0.2 kPa, respectively in 50 minutes. After that, the polymerization was advanced until predetermined stirring power was obtained. At the time point when the predetermined power was achieved, nitrogen was introduced into the reactor to return the pressure, and the produced polyester carbonate-based resin was extruded into water, followed by the cutting of a strand. Thus, a pellet was obtained.

The resultant polyester carbonate-based resin (pellet) was dried in a vacuum at 80°C for 5 hours, and then an elongate resin film having a thickness of 130 um was produced from the resin with a film-forming apparatus including a single-screw extruder (manufactured by Toshiba Machine Co., Ltd., cylinder set temperature: 250°C), a T-die (width: 200 mm, set temperature: 250°C), a chill roll (set temperature: from 120°C to 130°C), and a winding machine. The resultant elongate resin film was stretched in its widthwise direction at a stretching temperature of 140°C and a stretching ratio of 2.7 times.

Thus, a retardation film 1 having a thickness of 47 μm, an Re (590) of 143 nm, and an Nz coefficient of 1.2 was obtained. The resultant retardation film 1 had a ratio "Re(450)/Re(550)" of 0.856. In addition, the ISC value and thickness variation of the retardation film 1 are shown in Table 1.

[Production Example 1-2: Production of Retardation Film 2]

A retardation film 2 was obtained in the same manner as in Production Example 1-1 except that the stretching temperature was changed. The resultant retardation film 2 had a thickness of 47 μm, an Re(590) of 145 nm, an Nz coefficient of 1.2, and a ratio "Re(450)/Re(550)" of 0.856. In addition, the ISC value and thickness variation of the retardation film 2 are shown in Table 1.

[Production Example 1-3: Production of Retardation Film 3]

A retardation film 3 was obtained in the same manner as in Production Example 1-1 except that the stretching temperature was changed. The resultant retardation film 3 had a thickness of 47 μm, an Re(590) of 147 nm, an Nz coefficient of 1.2, and a ratio "Re(450)/Re(550)" of 0.856. In addition, the ISC value and thickness variation of the retardation film 3 are shown in Table 1.

Table 1

| Retardation film | ISC value | Thickness (μm) | | | | | | | ISC value/average thickness (μm) |
|---|---|---|---|---|---|---|---|---|---|
| | | Center | Upward | Downward | Leftward | Rightward | Average | Variation | |
| 1 | 15.0 | 47.3 | 46.8 | 47.1 | 47.0 | 47.3 | 47.1 | 0.50 | 0.32 |
| 2 | 17.7 | 47.2 | 47.7 | 47.3 | 47.5 | 47.3 | 47.4 | 0.60 | 0.37 |
| 3 | 19.0 | 47.2 | 47.1 | 47.6 | 47.1 | 47.5 | 47.3 | 0.40 | 0.40 |

[Production Example 2: Production of Polarizing Film]

An amorphous isophthalic acid-copolymerized polyethylene terephthalate film (thickness: 100 um) having an elongate shape and a Tg of about 75°C was used as a thermoplastic resin substrate. One surface of the resin substrate was subjected to corona treatment.

A product obtained by adding 13 parts by weight of potassium iodide to 100 parts by weight of a PVA-based resin, which had been obtained by mixing polyvinyl alcohol (polymerization degree: 4,200, saponification degree: 99.2 mol%) and acetoacetyl-modified PVA (manufactured by Mitsubishi Chemical Corporation, product name: "GOHSENX Z410") at 9:1, was dissolved in water to prepare a PVA aqueous solution (application liquid).

The PVA aqueous solution was applied to the corona-treated surface of the resin substrate, and was dried at 60°C to form a PVA-based resin layer having a thickness of 13 um. Thus, a laminate was produced.

The resultant laminate was uniaxially stretched in its longitudinal direction (lengthwise direction) at a ratio of 2.4 times in an oven at 130°C (in-air auxiliary stretching treatment).

Next, the laminate was immersed in an insolubilizing bath having a liquid temperature of 40°C (aqueous solution of boric acid obtained by blending 100 parts by weight of water with 4 parts by weight of boric acid) for 30 seconds (insolubilizing treatment).

Next, the laminate was immersed in a dyeing bath having a liquid temperature of 30°C (aqueous solution of iodine obtained by blending 100 parts by weight of water with iodine and potassium iodide at a weight ratio of 1:7) for 60 seconds while the concentration of the aqueous solution was adjusted so that the single layer transmittance (Ts) of an absorption-type polarizer to be finally obtained became a desired value (dyeing treatment).

Next, the laminate was immersed in a cross-linking bath having a liquid temperature of 40°C (aqueous solution of boric acid obtained by blending 100 parts by weight of water with 3 parts by weight of potassium iodide and 5 parts by weight of boric acid) for 30 seconds (cross-linking treatment).

After that, while the laminate was immersed in an aqueous solution of boric acid having a liquid temperature of 70°C (boric acid concentration: 4 wt%, potassium iodide concentration: 5 wt%), the laminate was uniaxially stretched in the longitudinal direction (lengthwise direction) between rolls having different peripheral speeds so that the total stretching ratio became 5.5 times (underwater stretching treatment).

After that, the laminate was immersed in a washing bath having a liquid temperature of 20°C (aqueous solution obtained by blending 100 parts by weight of water with 4 parts by weight of potassium iodide) (washing treatment).

After that, the laminate was brought into contact with a SUS-made heating roll whose surface temperature was kept at about 75°C while being dried in an oven kept at about 90°C (drying shrinkage treatment). The percentage by which the laminate was shrunk in its widthwise direction by the drying shrinkage treatment was 5.2%.

Thus, an absorption-type polarizer having a thickness of about 5 um was formed on the resin substrate.

A cycloolefin-based resin film (thickness: 25 um) was bonded as a protective layer to the surface of the resultant absorption-type polarizer (the surface opposite to the resin substrate) via a UV-curable adhesive. Specifically, the curable adhesive was applied so that its total thickness became about 1 $\mu$m, followed by the bonding with a roller machine. After that, a UV ray was applied from the cycloolefin-based resin film side to cure the adhesive. Next, the resin substrate was peeled.

Thus, a polarizing film having the configuration "cycloolefin-based resin film/absorption-type polarizer" was obtained. The polarizing film had a single layer transmittance (Ts) of 43.4% and a polarization degree of 99.993%.

[Example 1]

A laminate was obtained by laminating four retardation films 1 obtained in Production Example 1-1, and further laminating the polarizing film obtained in Production Example 2. The adjacent films were bonded to each other via an acrylic pressure-sensitive adhesive layer (manufactured by Nitto Denko Corporation, thickness: 5 um). The four retardation films were laminated as a $\lambda/4$ member 1, a $\lambda/4$ member 2, a $\lambda/4$ member 3, and a $\lambda/4$ member 4 in the stated order from one side in the axial relationship shown in Table 2. Then, the polarizing film was laminated on the $\lambda/4$ member 4. The angle shown in Table 2 is an axial angle of each member with respect to the absorption axis direction of the absorption-type polarizer of the polarizing film when the laminate is viewed from a $\lambda/4$ member 1 side, and the symbols "+" and "-" mean clockwise and counterclockwise, respectively.

Table 2

| $\lambda/4$ member | | | | Polarizing film |
|---|---|---|---|---|
| 1 | 2 | 3 | 4 | |
| -45° | -45° | +45° | + 45° | 0° |

[Example 2]

A laminate was obtained in the same manner as in Example 1 except that the retardation film 3 obtained in Production Example 1-3 was used instead of the retardation film 1 obtained in Production Example 1-1.

[Example 3]

A laminate was obtained in the same manner as in Example 1 except that the retardation film 2 obtained in Production Example 1-2 was used as each of the λ/4 member 2, the λ/4 member 3, and the λ/4 member 4.

[Example 4]

A laminate was obtained in the same manner as in Example 2 except that the retardation film 2 obtained in Production Example 1-2 was used as each of the λ/4 member 2, the λ/4 member 3, and the λ/4 member 4.

[Comparative Example 1]

A laminate was obtained in the same manner as in Example 1 except that the retardation film 3 obtained in Production Example 1-3 was used as each of the λ/4 member 2, the λ/4 member 3, and the λ/4 member 4.

[Comparative Example 2]

A laminate was obtained in the same manner as in Example 2 except that the retardation film 1 obtained in Production Example 1-1 was used as each of the λ/4 member 2, the λ/4 member 3, and the λ/4 member 4.

<Evaluation>

The single layer transmittance and polarization degree of the laminate of each of Examples and Comparative Examples were measured. Specifically, the single layer transmittance Ts, parallel transmittance Tp, and cross transmittance Tc of the laminate when linearly polarized light whose polarization direction was perpendicular to the absorption axis direction of the absorption-type polarizer was caused to enter the λ/4 member 1-side surface of the laminate were measured with a spectrophotometer (manufactured by Otsuka Electronics Co., Ltd., "LPF-200") . The Ts, the Tp, and the Tc are each a Y value measured with the two-degree field of view (C light source) of JIS Z 8701 and subjected to visibility correction. The polarization degree of the laminate was determined from the resultant Tp and Tc by using the equation described in the section (3).

The single layer transmittances, cross transmittances, and polarization degrees of the laminates are shown in Table 3. The laminates produced in Examples and Comparative Examples are each a simple evaluation model for the display system according to the embodiment of the present invention. Specifically, light, which has entered the laminate from the λ/4 member 1 side thereof and has been emitted from the polarizing film side thereof, can be evaluated as light obtained as follows in the display system according to the embodiment of the present invention: first linearly polarized light emitted from a display element to a front side through a polarizing member penetrates through a first retardation member and a second retardation member in the stated order, then further penetrates through the second retardation member twice through reflection by a reflecting portion and a half mirror, and then penetrates through the reflecting portion to be emitted to the front side.

Table 3

| | Retardation | | | | | | Laminate | | |
|---|---|---|---|---|---|---|---|---|---|
| | λ/4 member | | | | Difference | Value of formula (I) | Ts (%) | Tc (%) | P (%) |
| | 1 | 2 | 3 | 4 | | | | | |
| Example 1 | 143 nm | 143 nm | 143 nm | 143 nm | 0 nm | 0.0000 | 43.2 | 0.0126 | 99.9664 |
| Example 2 | 147 nm | 147 nm | 147 nm | 147 nm | 0 nm | 0.0000 | 43.1 | 0.0084 | 99.9774 |
| Example 3 | 143 nm | 145 nm | 145 nm | 145 nm | 2 nm | 0.0139 | 43.1 | 0.0529 | 99.8573 |

(continued)

| | Retardation | | | | | | Laminate | | |
|---|---|---|---|---|---|---|---|---|---|
| | λ/4 member | | | | Difference | Value of formula (I) | Ts (%) | Tc (%) | P (%) |
| | 1 | 2 | 3 | 4 | | | | | |
| Example 4 | 147 nm | 145 nm | 145 nm | 145 nm | 2 nm | 0.0137 | 43.1 | 0.0608 | 99.8361 |
| Comparative Example 1 | 143 nm | 147 nm | 147 nm | 147 nm | 4 nm | 0.0276 | 43.1 | 0.1310 | 99.6467 |
| Comparative Example 2 | 147 nm | 143 nm | 143 nm | 143 nm | 4 nm | 0.0276 | 43.1 | 0.1144 | 99.6916 |

A high polarization degree can be achieved in each of Examples. According to such display system, light leakage can be suitably suppressed.

The present invention is not limited to the above-mentioned embodiment, and various modifications may be made thereto. For example, the configurations described in the above-mentioned embodiment may each be replaced by substantially the same configuration, a configuration having the same action and effect, and a configuration that can achieve the same object.

Industrial Applicability

The display system according to the embodiment of the present invention may be used in, for example, a display body such as a pair of VR goggles.

Reference Signs List

2 display system
12 display element
14 reflecting portion
14a reflection-type polarizing member
16 first lens portion
18 half mirror
20 first retardation member
22 second retardation member
24 second lens portion

Claims

1.    A display system configured to display an image to a user, comprising:

a display element having a display surface configured to emit light representing an image to a front side through a polarizing member;
a reflecting portion arranged on the front side of the display element, the reflecting portion including a reflection-type polarizing member and being configured to reflect the light emitted from the display element;
a first lens portion arranged on an optical path between the display element and the reflecting portion;
a half mirror arranged between the display element and the first lens portion, the half mirror being configured to transmit the light emitted from the display element and to reflect the light reflected by the reflecting portion toward the reflecting portion;
a first λ/4 member arranged on an optical path between the display element and the half mirror; and
a second λ/4 member arranged on an optical path between the half mirror and the reflecting portion,
wherein an absolute value of a difference between an in-plane retardation (a) of the first λ/4 member and an in-plane retardation (b) of the second λ/4 member is 3.5 nm or less.

2. The display system according to claim 1, wherein the in-plane retardation (a) of the first λ/4 member and the in-plane retardation (b) of the second λ/4 member satisfy the following formula (I):

$$((a)-(b))/((a)+(b)/2)\leq0.02\cdots(I).$$

3. The display system according to claim 1, wherein the first λ/4 member and the second λ/4 member each have an ISC value of 50 or less.

4. The display system according to claim 1, wherein the first λ/4 member and the second λ/4 member each have a thickness of 100 um or less.

5. The display system according to claim 1, wherein the first λ/4 member and the second λ/4 member each have a thickness variation of 1 um or less.

6. The display system according to claim 1, wherein the first λ/4 member and the second λ/4 member each have an ISC value of 1 or less per unit thickness.

7. The display system according to claim 1, wherein a polarization direction of light, which has been emitted through the polarizing member, and a reflection axis of the reflection-type polarizing member are substantially perpendicular to each other.

8. The display system according to claim 1,

   wherein an angle formed by an absorption axis of the polarizing member in the display element and a slow axis of the first λ/4 member is from 40° to 50°, and
   wherein an angle formed by the absorption axis of the polarizing member in the display element and a slow axis of the second λ/4 member is from 40° to 50°.

9. A display body, comprising the display system of any one of claims 1 to 8.

10. A method of producing a display body comprising the display system of any one of claims 1 to 8.

11. A display method, comprising the steps of:

    passing light representing an image, which has been emitted through a polarizing member, through a first λ/4 member;
    passing the light, which has passed through the first λ/4 member, through a half mirror and a first lens portion;
    passing the light, which has passed through the half mirror and the first lens portion, through a second λ/4 member;
    reflecting the light, which has passed through the second λ/4 member, toward the half mirror with a reflecting portion including a reflection-type polarizing member; and
    enabling the light, which has been reflected by the reflecting portion and the half mirror, to penetrate through the reflecting portion with the second λ/4 member,
    wherein an absolute value of a difference between an in-plane retardation (a) of the first λ/4 member and an in-plane retardation (b) of the second λ/4 member is 3.5 nm or less.

FIG. 1

Fig.2(a)

Fig.2(b)

FIG. 3

FIG. 4

## INTERNATIONAL SEARCH REPORT

International application No.

**PCT/JP2023/008811**

| A. | CLASSIFICATION OF SUBJECT MATTER |
|---|---|

*G02B 27/02*(2006.01)i; *G02B 3/00*(2006.01)i; *G02B 5/00*(2006.01)i; *G02B 5/08*(2006.01)i; *G02B 5/30*(2006.01)i; *G02B 13/00*(2006.01)i; *G02B 17/08*(2006.01)i; *G02C 7/00*(2006.01)i; *G02F 1/13*(2006.01)i; *G02F 1/13363*(2006.01)i; *G02F 1/1337*(2006.01)i; *G09F 9/00*(2006.01)i; *H04N 5/64*(2006.01)i; *H04N 5/66*(2006.01)i; *H04N 13/344*(2018.01)i; *H04N 13/346*(2018.01)i; *H05B 33/02*(2006.01)i; *H05B 33/10*(2006.01)i; *H05B 33/24*(2006.01)i; *H10K 50/00*(2023.01)i; *H10K 59/00*(2023.01)i

FI: G02B27/02 Z; G02B3/00 Z; G02B5/00 Z; G02B5/08 D; G02B5/30; G02B13/00; G02B17/08; G02C7/00; G02F1/13 505; G02F1/13363; G02F1/1337; G09F9/00 313; H04N5/64 511A; H04N5/66 Z; H04N13/344; H04N13/346; H05B33/02; H05B33/10; H05B33/14 A; H05B33/24; H10K59/00

According to International Patent Classification (IPC) or to both national classification and IPC

| B. | FIELDS SEARCHED |
|---|---|

Minimum documentation searched (classification system followed by classification symbols)

G02B27/02; G02B27/01; G02B3/00; G02B5/00; G02B5/08; G02B5/30; G02B13/00; G02B17/08; G02C7/00; G02F1/13; G02F1/13363; G02F1/1337; G09F9/00; H04N5/64; H04N5/66; H04N13/344; H04N13/346; H05B33/02; H05B33/10; H05B33/24; H10K50/00; H10K59/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2021/145446 A1 (FUJIFILM CORPORATION) 22 July 2021 (2021-07-22) paragraphs [0006]-[0331], fig. 1A, 1B | 1-11 |
| A | US 2020/0341315 A1 (FACEBOOK TECHNOLOGIES, LLC) 29 October 2020 (2020-10-29) entire text, all drawings | 1-11 |
| A | JP 2019-526075 A (APPLE INC.) 12 September 2019 (2019-09-12) entire text, all drawings | 1-11 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 April 2023** | **25 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

### INTERNATIONAL SEARCH REPORT
**Information on patent family members**

International application No.

**PCT/JP2023/008811**

| Patent document cited in search report | | | Publication date (day/month/year) | Patent family member(s) | | | Publication date (day/month/year) |
|---|---|---|---|---|---|---|---|
| WO | 2021/145446 | A1 | 22 July 2021 | US | 2022/0373729 | A1 | |
| | | | | paragraphs [0008]-[0760], fig. 1A, 1B | | | |
| | | | | CN | 114945856 | A | |
| US | 2020/0341315 | A1 | 29 October 2020 | WO | 2020/219437 | A1 | |
| | | | | EP | 3959548 | A1 | |
| | | | | CN | 113767310 | A | |
| JP | 2019-526075 | A | 12 September 2019 | US | 2018/0039052 | A1 | |
| | | | | entire text, all drawings | | | |
| | | | | WO | 2018/026633 | A1 | |
| | | | | EP | 3479164 | A1 | |
| | | | | KR | 10-2019-0020826 | A | |
| | | | | CN | 110268301 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021103286 A
- JP 2014010291 A
- JP 2014026266 A
- JP 2015212816 A
- JP 2015212817 A
- JP 2015212818 A
- JP 2006163343 A
- JP 2006178389 A
- WO 2018123551 A1
- JP 2012073580 A
- JP 6470455 B